# EUROPÄISCHE PATENTANMELDUNG

(11) **EP 1 122 742 A2**
(43) Veröffentlichungstag der Anmeldung: **08.08.2001**
(21) Anmeldenummer: 01101749.8
(22) Anmeldetag: 25.01.2001
(51) Int. Cl.: G11C 29/00

(54) **Verfahren zum Testen der Refresheinrichtung eines Informationsspeichers**

(30) Priorität: 04.02.2000 DE 10004958
(71) Anmelder: Infineon Technologies AG, 81669 München (DE)
(72) Erfinder: Richter, Detlev, 81825 München (DE); Spirkl, Wolfgang, Dr., 82110 Germering (DE)
(74) Vertreter: MÜLLER & HOFFMANN Patentanwälte

(57) **Zusammenfassung**

Gegenstand der Erfindung ist ein Verfahren zum Testen der Refresheinrichtung eines Informationsspeichers, die folgendes enthält: eine Refresh-Wähleinrichtung zum Auswählen aufzufrischender Zellen des Speichers, eine Fühleinrichtung zum Fühlen des Zustandes jeder von der Wähleinrichtung ausgewählten Zelle und eine Rückspeichereinrichtung zum Setzen jeder ausgewählten Zelle in einen Frischzustand, der in einer die Auffrischung bewirkenden Refresh-Betriebsart der Rückspeichereinrichtung die aus dem gefühlten Zustand abgeleitete Information darstellt. Erfindungsgemäß werden zu Beginn des Tests die Zustände der am Test zu beteiligenden Zellen verifiziert, und vor Ablauf der garantierten Mindest-Retentionszeit der Speicherzellen nach dieser Verifizierung wird die Rückspeichereinrichtung in einer Test-Betriebsart betrieben, bei welcher der von ihr einzustellende Frischzustand jeder beteiligten Zelle jeweils ein vorgegebener Zustand ist, der sich fühlbar von dem zuvor verifizierten Zustand unterscheidet. Anschließend wird geprüft, ob die durch diesen Betrieb der Rückspeichereinrichtung eingestellten Zustände der beteiligten Zellen den vorgegebenen Zuständen entsprechen.

## Beschreibung

Die vorliegende Erfindung bezieht sich allgemein auf Informationsspeicher, die einer Refresheinrichtung bedürfen, um die in den Speicherzellen gehaltene Information in gewissen Zeitabständen aufzufrischen. Die Erfindung betrifft im einzelnen ein Verfahren zum Testen einer solchen Refresheinrichtung, gemäß dem Oberbegriff des Patentanspruchs 1. Ein wichtiges, jedoch nicht ausschließliches Anwendungsgebiet der Erfindung sind sogenannte DRAMs (Dynamic Random Access Memories), d.h. dynamische Speicher mit direktem Zugriff, insbesondere Halbleiterspeicher dieser Gattung.

Es hängt von der Natur der in einem Informationsspeicher verwendeten Speicherzellen ab, inwieweit ein durch Einschreiben einer Information geprägter Zellenzustand stabil bleibt. Bestehen die Zellen aus bistabilen elektrischen Schaltkreisen (Flipflops), dann bleibt die eingeschriebene Information erhalten, solange die Stromversorgung nicht unterbrochen wird. Gewisse Speicherzellen anderen Typs sind jedoch so beschaffen, daß sie die eingeschriebene Information im Lauf der Zeit verlieren und deswegen von Zeit zu Zeit "aufgefrischt" werden müssen.

Dies gilt beispielsweise für Speicherzellen, in denen das eigentliche Speicherelement eine elektrische Kapazität (Kondensator) mit verschiedenen möglichen Ladezuständen ist, wobei eine eingeschriebene Information durch den Pegel der Ladung dargestellt wird. Infolge unvermeidlicher Leckage des Kondensators verflüchtigt sich die eingebrachte Ladung im Lauf der Zeit so weit, daß eine durch eingebrachte Ladung dargestellte Information nicht mehr eindeutig erkennbar ist. Der Zellenzustand kann dann beim Lesen falsch interpretiert werden. Werden die Zellen als Binärspeicher betrieben, indem nur zwischen den beiden Zellenzuständen "geladen" (Hoch- bzw. H-Pegel) und "entladen" (Niedrig- bzw. L-Pegel) unterschieden wird, für die Darstellung der Binärwerte "1" und "0", dann kann nach gewisser Zeit die Ladung einer mit "1" beschriebenen Zelle so weit abgeklungen sein, daß an dieser Zelle eine "0" gelesen wird. Ganz ähnliche Probleme ergeben sich in noch stärkerem Maß, wenn die Zellen jeweils zur Speicherung von mehr als zwei diskreten Informationswerten benutzt werden, indem manche Informationswerte bestimmten Zwischenpegeln der Ladung zugeordnet werden.

Neben den vorstehend erwähnten kapazitiven Speicherzellen können auch andersartige Speicherzellen einer Auffrischung bedürfen. Generell gilt dies für alle Arten von Speicherzellen, in denen zumindest einer der informationsbeschreibenden Zustände flüchtig ist. Dabei können diese Zustände beliebiger physikalischer oder chemischer Natur sein.

Eine Auffrischung (Refresh) beinhaltet im Prinzip folgendes: der Zellenzustand wird rechtzeitig abgefühlt, bevor er sich derart weit verflüchtigt haben könnte, daß die von ihm repräsentierte Information nicht mehr eindeutig erkennbar wäre; anschließend wird die aus dem abgefühlten Zellenzustand erkannte Information frisch in die betreffende Zelle eingeschrieben.

Die Haltbarkeitsdauer einer Information in einer Zelle, d.h. die "Retentionszeit", über welche die eingeschriebene Information in der Zelle eindeutig erkennbar bleibt, ist konstruktionsbedingt und kann innerhalb desselben Speichermoduls von Zelle zu Zelle sehr unterschiedlich sein. Bei handelsüblichen, kapazitiv speichernden DRAMs liegt die garantierte Mindest-Retentionszeit einer "1" (also der durch den H-Pegel beschriebenen Information) meist bei einigen Millisekunden, während die tatsächliche Retentionszeit der "1" in einigen Zellen zufällig weit mehr betragen kann, in manchen Fällen sogar bis zu einigen Sekunden. Bei der Wahl der zeitlichen Abstände für die Auffrischung muß man sich jedoch, schon aus organistorischen Gründen, nach der garantierten Mindest-Retentionszeit richten, d.h. die Intervalle zwischen den Auffrischungen dürfen nicht länger sein als diese Zeitspanne.

Ein Informationsspeicher, dessen Zellen der Auffrischung bedürfen, benötigt und benutzt bekanntermaßen eine Refresheinrichtung mit folgenden Bestandteilen: eine Refresh-Wähleinrichtung zum Auswählen aufzufrischender Zellen des Speichers; eine Fühleinrichtung zum Fühlen des Zustandes jeder von der Refresh-Wähleinrichtung ausgewählten Zelle; eine Rückspeichereinrichtung zum Setzen jeder ausgewählten Zelle in einen frischen Zustand. Die derart aufgebaute Refresheinrichtung wird normalerweise automatisch in derartiger Weise betrieben, daß die Wähleinrichtung alle Speicherzellen entsprechend einem vom Benutzer eingestellten Folgeprogramm anwählt, daß die Fühleinrichtung den Zustand jeder angewählten Zelle fühlt und daß die Rückspeichereinrichtung die betreffende Zelle frisch in denjenigen Zustand setzt, welcher der aus dem gefühlten Zustand abgeleiteten Information entspricht. Das besagte Folgeprogramm der Refresh-Wähleinrichtung muß vom Benutzer so gestaltet werden, daß keine Zelle länger als die garantierte Mindest-Retentionszeit des Speichers unaufgefrischt bleibt.

Bei der Design-Analyse und im Produktionstest muß geprüft werden, ob die Refresheinrichtung die gewünschte Auffrischung zuverlässig und an allen anzuwählenden Zellen durchführen kann. Eine Fehlfunktionen kann z.B. darin bestehen, daß die Refresh-Wähleinrichtung dem eingestellten Programm nicht korrekt folgt. Dies kann insbesondere dann vorkommen, wenn in besagter Wähleinrichtung ein zyklisch betriebener Refreshzähler zur zyklisch wiederholten Anwahl der Adressen der aufzufrischenden Zellen oder Zellengruppen verwendet wird und die Überlauffunktion dieses Zählers nicht richtig arbeitet oder der Zähler auf andere Weise stottert. Eine andere Fehlfunktion kann darin bestehen, daß eine zum Abfühlen angewählte Zelle von der Rückspeichereinrichtung nicht erreicht wird.

Zum Testen der Refresheinrichtung genügt es nicht, eine bekannte, zur Flüchtigkeit neigende Information in das gesamte Zellenfeld einzuspeichern, dann kurz vor Ablauf der Mindest-Retentionszeit einen Refreshzyklus über alle Zellen durchzuführen und anschließend zu nachzuprüfen, ob alle Zellen immer noch die eingespeicherte Information enthalten. Diejenigen Zellen nämlich, deren tatsächliche Retentionszeit deutlich über der Mindest-Retentionszeit liegt, können zum Zeitpunkt der Nachprüfung ihre Information auch dann behalten haben, wenn sie beim Refreshzyklus übergangen worden sind.

Zur Lieferung eines wirklich aussagekräftigen Testergebnisses ist es daher üblich, nach dem Einspeichern der Information viele aufeinanderfolgende Refreshzyklen durchzuführen, in Abständen von jeweils nicht größer als der Mindest-Retentionszeit, insgesamt aber über eine Dauer, die höher ist als die zu erwartende maximale Retentionszeit. Nur so kann anhand des anschließend gefühlten Informationsinhaltes der Zellen festgestellt werden, ob und welche Zellen bei den Refreshzyklen regelmäßig übergangen wurden. Diese Methode erfordert jedoch lange Testzeiten und scheidet daher insbesondere dann aus, wenn die Tests bei einem größeren Speicher nur abschnittsweise an kleinen Speicherblöcken durchzuführen sind.

Als Alternative könnte man sich damit begnügen, nicht das Auffrischungsergebnis selbst, sondern nur die Arbeitsweise des Refreshzählers zu überprüfen. Hiermit können jedoch manche Fehlerzustände wie etwa die fehlende tatsächliche Erreichbarkeit einer angewählten Zelle nicht erkannt werden. Ein Fehler beispielsweise in der Verdrahtung zwischen dem Refreshzähler und dem Adressendecoder bliebe unbemerkt, ebenso ein Fehler im Multiplexer, der üblicherweise zur Selektion zwischen normaler Adresse und Refreshadresse vorgesehen ist. Außerdem erfordert eine Zählerprüfung die Detektion des jeweils existierenden Zählstandes (momentaner Zählwert), um etwaige Fehler im Zählerbetrieb feststellen zu können. Bei vielen Refreshzählern sind Mittel zur Anzeige des Zählerstandes oder eines definierten Rücksetzzustandes nicht vorgesehen, so daß man in diesen Fällen zusätzliche Detektions-Hardware für den Test braucht, z.B. eine spezielle Scankette.

Die Aufgabe der Erfindung besteht darin, zum Testen der Refresheinrichtung eines Informationsspeichers ein Verfahren vorzusehen, das in kurzer Testzeit Aussagen liefert, anhand derer feststellbar ist, ob alle Bestandteile der Refresheinrichtung vorschriftsmäßig arbeiten. Diese Aufgabe wird erfindungsgemäß durch die kennzeichnenden Merkmale des Patentanspruchs 1 gelöst. Vorteilhafte Ausführungsformen der Erfindung sind in den Unteransprüchen gekennzeichnet.

Als Grundprinzip beinhaltet das erfindungsgemäße Testverfahren die Schritte,
- daß zu Beginn des Tests die Zustände der am Test zu beteiligenden Zellen verifiziert werden;
- daß vor Ablauf der garantierten Mindest-Retentionszeit nach dieser Verifizierung die Rückspeichereinrichtung in einer Test-Betriebsart betrieben wird, bei welcher der von ihr einzustellende Frischzustand jeder beteiligten Zelle jeweils ein vorgegebener Zustand ist, der sich fühlbar von dem zuvor verifizierten Zustand unterscheidet;
- daß geprüft wird, ob die durch diesen Betrieb der Rückspeichereinrichtung eingestellten Zustände der beteiligten Zellen den vorgegebenen Zuständen entsprechen.

Die Erfindung beruht im Grunde auf zwei Erkenntnissen. Die eine Erkenntnis ist, daß die oben erwähnten Probleme bei Refreshtests letztlich daher rühren, daß der bestimmungsgemäße Betrieb der Rückspeichereinrichtung den Auftrag beinhaltet, in die jeweils ausgewählte Zelle eine Information rückzuspeichern, welche die gleiche wie die zuvor abgefühlte Information ist. Zum anderen wurde erkannt, daß eine gezielte Abkehr von diesem bestimmungsgemäßen Betrieb, nämlich eine Test-Betriebsart mit dem Auftrag zur Rückspeicherung einer eindeutig anderen als der gefühlten Information, praktisch alle eventuellen Fehler sämtlicher Bestandteile der Refresheinrichtung offenbaren kann. Das heißt, jeder Fehler, der den Erfolg eines echten Refreshbetriebs beeinträchtigen würde oder könnte, äußert sich erkennbar auch im Ergebnis der besagten Test-Betriebsart der Rückspeichereinrichtung. Durch die erfindungsgemäße Test-Betriebsart werden also die oben erwähnten Probleme umgangen, und trotzdem behält das Testergebnis uneingeschränkte Aussagekraft.

Die zu Beginn des Tests erfolgende Verifizierung von Zellenzuständen kann darin bestehen, die Zustände der betroffenen Zellen, sofern sie noch unbekannt sind, zu fühlen, z.B. durch normales Auslesen der darin gespeicherten Information. Die Verifizierung kann aber auch dadurch erfolgen, daß irgendeine bekannte Information durch einen normalen Schreibbetrieb in die Zellen eingeschrieben wird (so daß das Lesen überflüssig ist) .

Diese bekannte Information muß nicht für alle betroffenen Zellen gleich sein, vorzugsweise ist sie es aber, so daß alle diese Zellen den gleichen bekannten Zustand einnehmen. Dies hat den Vorteil, daß auch die anschließend in der Test-Betriebsart der Rückspeichereinrichtung einzustellenden Zellenzustände einander gleich sein können, was diesen Betrieb und auch die anschließende Auswertung vereinfacht. Man braucht in die Rückspeichereinrichtung an geeigneter Stelle (dort, wo sonst der Pegel anliegt, der die Information des vorherigen Zellenzustandes beschreibt) nur irgendeinen definierten festen Pegel einzuspeisen, der zu einem vom eingeschriebenen Zustand unterscheidbaren Zellenzustand führt. Dieser neue ("frische") Zellenzustand braucht nicht einmal eindeutig eine Speicherinformation zu beschreiben, er kann auch irgendein Zwischenzustand sein. Vorzugsweise, zur Erleichterung der Auswertung, ist der neu einzustellende Zellenzustand jedoch einer der möglichen Speicherinformationen zugeordnet, im Falle binärer Speicherzellen etwa einer "1", wenn die zuvor eingeschriebene Information eine "0" ist.

Bei dieser speziellen Ausführungsform enthalten alle betroffenen Speicherzellen nach einem Zyklus, der in der Test-Betriebsart der Rückspeichereinrichtung vollführt wurde, eine "1", falls die Refresheinrichtung fehlerfrei ist. Erscheint irgendwo eine "0", ist auf eine Fehlfunktion der Refresheinrichtung bezüglich der betreffenden Zelle (oder Zellengruppe) zu schließen.

Wie bereits weiter oben erwähnt, enthalten Refresh-Wähleinrichtungen häufig einen Refreshzähler, der durch Refresh-Taktimpulse zyklisch über jeweils einen Zählbereich fortschaltbar ist, welcher N Zählwerte (0 bis N-1) umfaßt, um eine Menge von N Zellen oder Zellengruppen des Speichers in zyklischer Wiederholung für die Auffrischung zu adressieren. In diesen Fällen wird das erfindungsgemäße Testverfahren vorzugsweise so durchgeführt, daß nach Einschreiben einer bekannten Information in die am Test zu beteiligenden Zellen und vor Ablauf der Mindest-Retentionszeit der Refreshzähler durch aufeinanderfolgende Taktimpulse fortgeschaltet wird, unter Betreiben der Rückspeichereinrichtung in der Test-Betriebsart, um die nacheinander adressierten Zellen in die durch diese Betriebsart vorgegebenen "neuen" Zustände zu setzen. Anschließend wird geprüft, inwieweit diese neuen Zustände tatsächlich erreicht worden sind.

Wenn man diesen Test über genau N Taktimpulse durchgeführt hat, sollte man annehmen, daß alle N Adressen W₀ bis W_{N-1} für die N Elemente der zu beteiligenden Menge von Zellen oder Zellengruppen durchlaufen worden sind. Diese Annahme wäre allerdings nur dann gerechtfertigt, wenn der Zähler und der den Zählwert in die jeweils zugeordnete Adresse übersetzende Decoder korrekt arbeiten. Ist diese Idealbedingung erfüllt, dann offenbart ein Testzyklus mit genau N Taktimpulsen, ob für jede erzeugte Adresse das jeweils zugeordnete Element der Menge auch tatsächlich von der Rückspeichereinrichtung erreicht wurde. Das heißt, ein einfacher Test mit N Taktimpulsen ist nur sinnvoll, wenn man darauf vertrauen kann, daß Zähler und Decoder fehlerfrei sind.

Kann man hingegen nicht auf diesen Idealfall vertrauen, wird das erfindungsgemäße Verfahren vorzugsweise in besonderer Strategie durchgeführt, um eventuelle Fehler, die bei der Refreshadressenerzeugung vorkommen können, ebenfalls zu berücksichtigen oder gar zu erkennen. Solche Fehler können sein:
i. der Zähler überspringt Zählwerte oder stockt vorübergehend über einen oder mehrere Impulse;
ii. der Überlauf des Zählers (d.h. die Rückkehr vom Ende zum Anfang des Zählbereichs) funktioniert nicht richtig, etwa indem hierbei ein zusätzlicher Taktimpuls verbraucht wird;
iii. der Zählwertdecoder für die Adressenerzeugung funktioniert nicht richtig oder hat keine Verbindung zum Zählerausgang;
iv. ein eventuell vorhandener Umschalter (Multiplexer), der zur Selektion zwischen normaler Adresse und Refreshadresse dient, ist fehlerhaft.

Im ungünstigsten Fall, wenn am Zähler keine Mittel zur Bekanntgabe des Zählwertes oder zum Voreinstellen eines definierten Zählwertes (etwa zur gezielten Rücksetzung auf 0) vorhanden sind, wird vorzugsweise folgender Testablauf realisiert: Zunächst werden alle N auszuwählenden Elemente (Zellen oder Zellengruppen) der am Test beteiligten Menge durch normales Einschreiben in einen bekannten Zustand gesetzt (beispielsweise auf L-Pegel). Dann werden, innerhalb der Mindest-Retentionszeit und unter Betreiben der Rückspeichereinrichtung in der Test-Betriebsart, N aufeinanderfolgende Taktimpulse an den Refreshzähler gelegt, und die "neuen" Zustände der N Elemente werden ausgelesen. Anschließend wird, wiederum innerhalb der Mindest-Retentionszeit aber unter Betreiben der Rückspeichereinrichtung in der Refresh-Betriebsart, eine Anzahl Y von Taktimpulsen an den Zähler gelegt, wobei Y irgendeine andere Zahl als ein ganzzahliges Vielfaches von N ist (vorzugsweise wird Y=N/2 gewählt). Dann werden erneut alle N auszuwählenden Elemente in einen bekannten Zustand gesetzt, und erneut werden innerhalb der Mindest-Retentionszeit, diesmal wieder unter Betreiben der Rückspeichereinrichtung in der Test-Betriebsart, N aufeinanderfolgende Taktimpulse an den Refreshzähler gelegt, und die resultierenden Zustände der N Elemente werden ausgelesen.

Wenn alle Teile der Refresheinrichtung fehlerfrei sind, zeigen die beiden Auslesungen in allen N Elementen jeweils die von der Rückspeichereinrichtung vorgegebenen Zellenzustände. Die Zwischenschaltung der Y echten Refreshoperationen soll garantieren, daß zumindest einer der beiden N-teiligen Testzyklen einen Überlauf des Refreshzählers beinhaltet, so daß sich eventuelle Überlauffehler im Testergebnis äußern. Das heißt, es wird sichergestellt, daß während des zweiten Testzyklus ein Überlauf durchschritten wird, sofern dies nicht beim ersten Testzyklus erfolgt ist. Die Zahl Y=N/2 wird vorzugsweise gewählt, weil sie die kleinste derjenigen Zahlen ist, die den größtmöglichen Abstand von ganzzahligen Vielfachen (inklusive 0) von N haben. So besteht auch bei etwaigen Überspringungen und Stockungen im Zählerbetrieb optimale Wahrscheinlichkeit, daß der Überlauf innerhalb des einen oder anderen Testzyklus durchschritten wird.

Bei dem vorstehend beschriebenen Testablauf werden für den Test insgesamt 2N+N/2 Taktimpulse benötigt. Die beiden Auslesungen geben zusammengenommen Aufschluß darüber, ob die Rückspeichereinrichtung grundsätzlich jedes der N Elemente erreicht und ob die Überlauffunktion des Zählers korrekt arbeitet. Wird beispielsweise vor jedem der beiden Testzyklen der Binärzustand "0" an allen N Elementen eingeschrieben (z.B. L-Pegel) und beschreibt der von der Rückspeichereinrichtung vorgegebene Zustand eine "1" (H-Pegel), dann zeigt jede der beiden Auslesungen den Binärzustand "1" (H-Pegel) an allen Elementen, falls alle Teile fehlerfrei arbeiten. Wo statt der zu erwartenden "1" eine "0" ausgelesen wird, liegt eine Fehlfunktion der Refresheinrichtung vor.

Sind am Zähler Mittel zur Bekanntgabe des Zählstandes oder zum Voreinstellen eines definierten Zählwertes vorgesehen, dann kann der Testablauf gegenüber dem vorstehend beschriebenen Fall verkürzt werden. Zunächst wird der Zählstand des Refreshzählers verifiziert, d.h. abgelesen oder auf einen bekannten Zählwert A gesetzt (z.B. 0), und alle N auszuwählenden Elemente (Zellen oder Zellengruppen) der am Test beteiligten Menge werden durch normales Einschreiben in einen bekannten Zustand gesetzt (beispielsweise alle auf L-Pegel). Dann werden, innerhalb der Mindest-Retentionszeit und unter Betreiben der Rückspeichereinrichtung in der Test-Betriebsart, X<N aufeinanderfolgende Taktimpulse an den Refreshzähler gelegt, und anschließend werden die Zustände aller N Elemente zum ersten Mal ausgelesen. Anschließend werden wiederum alle N auszuwählenden Elemente in einen bekannten Zustand gesetzt (z.B. alle auf L-Pegel). Dann werden, innerhalb der Mindest-Retentionszeit und unter Betreiben der Rückspeichereinrichtung in der Test-Betriebsart, N-X+1 aufeinanderfolgende Taktimpulse an den Refreshzähler gelegt, und anschließend werden die Zustände aller N Elemente zum zweiten Mal ausgelesen.

Je nachdem, ob die Zahl A+X kleiner oder größer ist als N, wird der Überlauf des Zählers beim zweiten oder beim ersten Testzyklus durchschritten. Bei fehlerfreiem Betrieb aller Teile der Refresheinrichtung ergeben sich folgende Situationen:
1) Im ersten Fall (also A+X<N) zeigt
   1a) die erste Auslesung an den Adressen W_{A} bis W_{A+X-1} den von der Rückspeichereinrichtung in der Test-Betriebsart vorgegebenen Zustand und an den übrigen Adressen den jeweils zuvor verifizierten Zustand, und
   1b) die zweite Auslesung an den Adressen W_{A+X} bis W_{N-1} und von W₀ bis W_{A} den von der Rückspeichereinrichtung in der Test-Betriebsart vorgegebenen Zustand und an den übrigen Adressen den jeweils zuvor verifizierten Zustand.
2) Im zweiten Fall (also (A+X>N) zeigt
   2a) die erste Auslesung an den Adressen W_{A} bis W_{N-1} und an den Adressen W₀ bis W_{A+X-N-1} den von der Rückspeichereinrichtung in der Test-Betriebsart vorgegebenen Zustand und an den übrigen Adressen den jeweils zuvor verifizierten Zustand, und
   2b) die zweite Auslesung an den Adressen W_{A+X-N} bis W_{A} den von der Rückspeichereinrichtung in der Test-Betriebsart vorgegebenen Zustand und an übrigen Adressen den jeweils zuvor verifizierten Zustand.

Bei diesen Testabläufen werden für den Test insgesamt nur N+1 Taktimpulse benötigt. Beide Auslesungen zusammengenommen zeigen, ob die Rückspeichereinrichtung grundsätzlich alle Elemente erreicht. Die Auslesung nach demjenigen Testzyklus, in welchem der Überlauf des Zählers durchschritten wurde, zeigt, ob die Überlauffunktion korrekt arbeitet.

Ist das gesamte System so ausgebildet, daß bei jedem Reset (z.B. bei der Initialisierung des Systems) der Refreshzähler definiert auf 0 gesetzt wird, dann ist auch zu Beginn des Testablaufs von diesem Zählstand auszugehen, also A=0. Als Beispiel sei angenommen, daß X=N-1 und daß vor jedem der beiden Testzyklen der Binärzustand "0" an allen N Elementen eingeschrieben wird (z.B. L-Pegel) und daß der von der Rückspeichereinrichtung vorgegebene Zustand eine "1" darstellt (H-Pegel). In diesem Fall zeigt bei fehlerfreiem Betrieb die erste Auslesung den Binärzustand "1" (H-Pegel) an den Adressen W₀ bis W_{N-2} und den Binärzustand "0" (L-Pegel) an der Adresse W_{N-1}; die zweite Auslesung zeigt den Binärzustand "1" an den Adressen W_{N-1} und W₀ und den Binärzustand "0" (L-Pegel) an den Adressen W₁ bis W_{N-2}. Wo statt einer zu erwartenden "1" eine "0" ausgelesen wird, ist auf eine Fehlfunktion der Refresheinrichtung zu schließen.

Bei dem zweiten Testzyklus können auch mehr als N-X+1 Taktimpulse angelegt werden. Eine Anzahl von genau N-X+1 genügt jedoch im allgemeinen, um ein Überspringen oder Stocken im Betrieb des Refreshzählers über das Maß von 1 Taktimpuls sicher zu erkennen.

Bei den üblichen DRAM-Speichern, die eine Matrix aus N Zeilen und M Spalten von Speicherzellen aufweisen (meistens ist M=N), wird zur Auffrischung im normalen Betrieb vom Refreshzähler jeweils eine ganze Zeile (M Zellen) ausgewählt, durch selektives Öffnen der betreffenden Zeilenadressenleitung ("Wortleitung"), während sämtliche Spaltenadressenleitungen ("Bitleitungen") geöffnet sind. Beim Vorhandensein von N Zeilen mit den Wortleitungsadressen W₀ bis W_{N-1} enthält also jedes der N "Elemente" der vom Refreshzähler auszuwählenden Menge jeweils M Zellen. Um zu testen, ob die Adressierung durch den Refreshzähler ordnungsgemäß funktioniert, kann es genügen, bei dem erfindungsgemäßen Verfahren im Verlauf der Testzyklen jeweils nur eine dieser Zellen in jeder Zeile zu beobachten, indem beim Verifizieren von Zellenzuständen vor dem Test (z.B. beim Einschreiben) und beim Prüfen der Zellenzustände nach dem Test (also beim Auslesen) nur eine und jeweils dieselbe Spaltenadresse angesteuert wird.

In Speichermodulen wird der Speicher oft in mehrere Bänke aufgeteilt, d.h. in Bereiche von Wortleitungen, so daß zur selben Zeit in jeder Bank eine Wortleitung geöffnet sein darf. Daraus folgt für den Refreshbetrieb, daß es grundsätzlich möglich ist, Zellen an b Wortleitungen gleichzeitig aufzufrischen, wenn b die Anzahl der Bänke ist.

Wenn für jede Bank ein eigener Refreshzähler vorgesehen ist, so können die erfindungsgemäßen Refreshtests unverändert für jede Bank durchgeführt werden, und zwar parallel oder seriell. Im anderen Fall, wenn ein einziger Zähler für b Bänke vorhanden ist, kommt es zu einem komplexen Verhalten. Nur die selektierten Bänke werden aufgefrischt, der gemeinsame Zähler inkrementiert jedoch bei jedem Refreshvorgang. Werden beispielsweise zwei Bänke A und B (b=2) mit jeweils N Wortleitungen alternierend aufgefrischt, beginnend mit der Bank A, dann ist nach N Refreshereignissen jede Wortleitung mit ungerader Ordnungszahl in A und jede Wortleitung mit gerader Ordnungszahl in B aufgefrischt. Auch dieses Verhalten kann mit dem erfindungsgemäßen Refreshtestverfahren geprüft werden, durch entsprechende Erweiterung der oben beschriebenen Testmuster. Speziell lassen sich anhand der Zellenzustände, die jeweils nach einer erfindungsgemäßen Test-Betriebsart der Refresheinrichtung ausgelesen werden, Fehlfunktionen der Refresheinrichtung beim parallelen Auffrischen, beim seriellen Auffrischen und beim Auffrischen nach gemischtem Muster erkennen, wenn man das Testmuster entsprechend erweitert.

Zur Durchführung des erfindungsgemäßen Testverfahrens ist praktisch keine zusätzliche Hardware an der zu testenden Refresheinrichtung notwendig. Die einzig durchzuführende Modifikation ist die Schaffung einer Umschaltmöglichkeit zwischen der normalen Refresh-Betriebsart und der Test-Betriebsart der Rückspeichereinrichtung. Insbesondere wenn in bevorzugter Ausführungsform der Erfindung die Verifizierung der Zellenzustände vor dem Testbetrieb durch Einschreibung der jeweils gleichen Information wie etwa des L-Pegels in alle beteiligten Zellen erfolgt, ist die Umschaltung in die Test-Betriebsart denkbar einfach: es braucht nur ein einziger, vom L-Pegel unterscheibarer Pegel (z.B. der H-Pegel) bereitgestellt und jeweils zu gegebener Zeit an den Ausgang der Rückspeichereinrichtung gelegt zu werden.

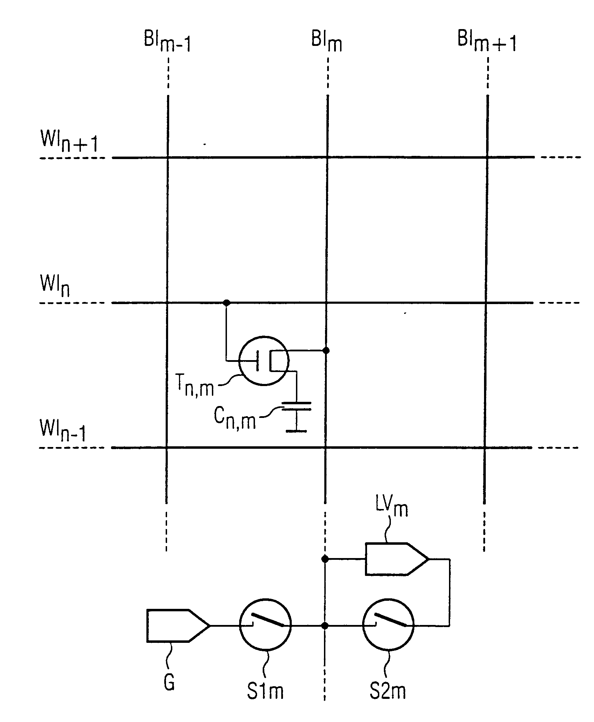

Bei den gebräuchlichen Halbleiter-DRAMs mit binärer kapazitiver Speicherung wird als Rückspeichereinrichtung ein Transistorschalter verwendet, der im Leseverstärker vorhanden ist und beim Lesen einer Zelleninformation in einen Schaltzustand gerät, bei welchem seine "Ausgangselektrode" auf dem die gelesene Information anzeigenden Pegel liegt. Im normalen Lesebetrieb wird unmittelbar nach dem Lesen, bei noch geöffneter Wortleitung (Zeilenadressenleitung), eine Verbindung von dieser Elektrode zur betreffenden Bitleitung (Spaltenadressenleitung) kurzzeitig aufrechterhalten, so daß ein Wiedereinschreiben der gelesenen Information in die betreffende Zelle erfolgt. Das gleiche geschieht beim normalen Refreshbetrieb, der im Grunde nichts anderes als ein Lesebetrieb ist (allerdings ohne weitere Verarbeitung des Ausgangssignals des Leseverstärkers). Zur Realisierung der erfindungsgemäßen Test-Betriebsart genügt es, den besagten Transistorschalter von außen so anzusteuern bzw. seiner Ausgangselektrode oder der betreffenden Bitleitung ein derartiges Potential aufzuprägen, daß sich beim Wiedereinschreiben der für die Test-Betriebsart vorgegebene Zellenzustand ergibt. Dies kann in einer sehr einfachen Weise erfolgen, wie es nachstehend anhand der beigefügten Zeichnung erläutert wird.

Die Zeichnungsfigur zeigt schematisch einen Ausschnitt aus einem DRAM-Speichermodul mit kapazitiver Speicherung. Im einzelnen dargestellt ist eine Speicherzelle, die über eine Wortleitung WLₙ (Zeilenadressenleitung) und eine Bitleitung BLₘ (Spaltenadressenleitung) adressierbar ist. Die Zelle besteht aus der Speicherkapazität C_{n,m}, deren eine Seite an Bezugspotential ("Masse") angeschlossen und deren andere Seite über den Kanal eines zugehörigen Speicherzellentransistors ("Auswahltransistor") T_{n,m} an die Bitleitung BLₘ durchgeschaltet wird, wenn die mit der Gateelektrode des Transistors T_{n,m} verbundene Wortleitung WLₙ angesteuert wird. Das Speichermodul enthält natürlich eine Vielzahl weiterer gleichartiger Zellen, die eine Matrix von Zeilen und Spalten bilden, wobei jeder Zeile eine individuelle Wortleitung und jeder Spalte eine individuelle Bitleitung zugeordnet ist. In der Figur sind neben der Wortleitung WLₙ nur die jeweils unmittelbar benachbarten Exemplare WLₙ₋₁, WLₙ₊₁ und neben der Bitleitung BLₘ nur die jeweils unmittelbar benachbarten Exemplare BLₘ₋₁, BLₘ₊₁ gezeigt. Jede Bitleitung (oder jedes Bitleitungspaar im Falle gepaarter bzw. zweigeteilter Bitleitungen) ist an eine zugeordnete Schreib/Leseschaltung angeschlossen, die u.a. einen Leseverstärker zum Fühlen des Ladezustandes der Speicherkapazität und ein Schaltersystem für das Laden der Speicherkapazität auf ausgewählte Spannungspegel enthält. Der Betrieb einer solchen Schaltung zum normalen Schreiben und Lesen der Speicherinformation (und auch zum Rückspeichern der Information nach dem Lesen) ist allgemein bekannt und braucht hier nicht erklärt zu werden. In der Figur sind nur Teile der an eine Bitleitung (BLₘ) angeschlossenen Schaltung gezeigt, soweit es zur Erläuterung des normalen Refreshbetriebs und des erfindungsgemäßen Testbetriebs hilfreich ist. Bei dieser nachstehenden Erläuterung wird vereinfachend von jeweils einer einzigen Bitleitung anstelle der gebräuchlichen Bitleitungspaare gesprochen.

Ein gewöhnlicher Refreshbetrieb an irgendeiner Zelle, beispielsweise an der dargestellten Zelle mit der Speicherkapazität C_{n,m}, läuft folgendermaßen ab:
- Schritt 1:: Die betreffende Bitleitung startet (genau so wie beim normalen Lesevorgang) im "vorgeladenen" Zustand auf einem Spannungspegel V₁, der durch einen Generator G zur Verfügung gestellt wird. Hierzu wird ein Vorladeschalter S1ₘ zwischen dem Generator G und der Bitleitung BLₘ geschlossen.
- Schritt 2:: Der Schalter S1ₘ wird nun geöffnet. Dann wird durch Ansteuerung der Wortleitung WLₙ der Auswahltransistor T_{n,m} leitend gemacht und somit die Speicherkapazität C_{n,m} auf die Bitleitung BLₘ geschaltet. Ist in der Zelle niedriger Pegel (L-Pegel) VL gespeichert, also der Binärwert "0", dann stellt sich die Bitleitungsspannung auf einen Pegel V₁-dV ein. Ist in der Zelle hoher Pegel (H-Pegel) VH gespeichert, also der Binärwert "1", dann stellt sich die Bitleitungsspannung auf einen Pegel V₁+dV ein. Typischerweise wird der Vorladepegel V₁=(VL+VH)/2 gewählt.
- Schritt 3:: Die Differenz zwischen der nun existierenden Bitleitungsspannung und der Vorladespannung V₁ wird im Leseverstärker LVₘ verstärkt. Durch Schließen eines bis dahin geöffneten Rückladeschalters S2ₘ, der zwischen dem Ausgang des Leseverstärkers LVₘ und der Bitleitung BLₘ angeordnet ist, wird der verstärkte Differenzwert über die Bitleitung BLₘ und den immer noch leitend gehaltenen Auswahltransistor T_{n,m} in die Speicherkapazität C_{n,m} zurückgeschrieben. Hiermit steht in der Speicherkapazität wieder der "aufgefrischte" Speicherpegel zur Verfügung.
- Schritt 4:: Durch Aberregung der Wortleitung WLₙ und das hieraus resultierende Sperren des Auswahltransistors T_{n,m} wird die Speicherkapazität C_{n,m} von der Bitleitung BLₘ abgetrennt, und durch Schließen des Vorladeschalters S1ₘ und Öffnen des Rückladeschalters S2ₘ wird die Bitleitung BLₘ wieder auf die Vorladespannung V₁ gebracht (= Schritt 1).
- Fortsetzung:: Die Schritte 1 bis 4 werden für die als nächstes ausgewählte Wortleitung wiederholt, z.B. für die Wortleitung WLₙ₊₁ zum Auffrischen der (nicht gezeigten) Speicherkapazität C_{n+1,m}.

In der Praxis werden üblicherweise alle Zellen einer Zeile gleichzeitig aufgefrischt, indem man alle Bitleitungen gleichzeitig gemäß den vorstehend beschriebenen Schritten 1 bis 4 ansteuert.

Unter Verwendung der in der Zeichnungsfigur dargestellten Elemente kann in einfacher Weise, ohne Hinzufügung weiterer Hardware-Komponenten, auch der erfindungsgemäße Refreshtest durchgeführt werden. Es ist nämlich ohne weiteres möglich, die Ansteuerung der Bitleitungen so zu ändern, daß statt der Ausgangsspannung des Leseverstärkers LVₘ die Ausgangsspannung V₁ des Generators G direkt in die Zellen geschrieben wird. Hierzu genügt es, die Schritte 1 bis 4 in der oben beschriebenen Folge durchzuführen, mit der einzigen Modifikation, daß der Vorladeschalter S1ₘ immer geschlossen (leitend) und der Rückladeschalter S2ₘ immer geöffnet (also niemals leitend) ist. Jede Ansteuerung der Wortleitung WLₙ wird dann ein Schreibzugriff für die ausgewählte Wortleitung, wobei die eingeschriebene Information von der Ausgangsspannung V₁ des Generators G diktiert ist.

Zur Realisierung der erfindungsgemäßen Test-Betriebsart wird die so modifizierte Schrittfolge für jede ausgewählte Wortleitung durchgeführt. Anders ausgedrückt: die durch die Schalter S1ₘ und S2ₘ und deren (nicht gezeigte) Ansteuerschaltung gebildete Rückspeichereinrichtung wird in die erfindungsgemäße Test-Betriebsart versetzt, indem das Wechselspiel der Schalter, das in der Refresh-Betriebsart zur Rückspeicherung der gefühlten Zelleninformation führt, geändert wird in ständiges Offenhalten des Schalters S2ₘ und ständiges Geschlossenhalten des Schalters S1ₘ, wobei der Generator G auf eine Spannung V₁ eingestellt wird, die beim Einschreiben in die Zelle zu dem für die Test-Betriebsart vorgegebenen Zellenzustand führt (hierzu muß der Generator G natürlich entsprechend eingestellt sein). Wenn man die Spannung V₁=VL setzt, schreibt man eine "0" in die Zellen; bei V₁=VH wird eine "1" eingeschrieben. Bei den weiter oben beschriebenen Ausführungsbeispielen, wo der zu Beginn des Refreshtests eingestellte Zellenzustand einer "0" entspricht, wird V₁=VH gesetzt.

## Patentansprüche

1. Verfahren zum Testen der Refresheinrichtung eines Informationsspeichers, die ausgelegt ist, um die Information, welche in einer Vielzahl von Zellen des Speichers als Zustand der jeweiligen Zelle gespeichert ist, jeweils vor Ablauf einer garantierten Mindest-Retentionszeit aufzufrischen, und die folgendes enthält:
eine Refresh-Wähleinrichtung zum Auswählen aufzufrischender Zellen des Speichers;
eine Fühleinrichtung zum Fühlen des Zustandes jeder von der Wähleinrichtung ausgewählten Zelle;
eine Rückspeichereinrichtung zum Setzen jeder ausgewählten Zelle in einen Frischzustand, der in einer die Auffrischung bewirkenden Refresh-Betriebsart der Rückspeichereinrichtung die aus dem gefühlten Zustand abgeleitete Information darstellt,
dadurch gekennzeichnet,
daß zu Beginn des Tests die Zustände der am Test zu beteiligenden Zellen verifiziert werden;
daß vor Ablauf der garantierten Mindest-Retentionszeit nach dieser Verifizierung die Rückspeichereinrichtung in einer Test-Betriebsart betrieben wird, bei welcher der von ihr einzustellende Frischzustand jeder beteiligten Zelle jeweils ein vorgegebener Zustand ist, der sich fühlbar von dem zuvor verifizierten Zustand unterscheidet;
daß geprüft wird, ob die durch diesen Betrieb der Rückspeichereinrichtung eingestellten Zustände der beteiligten Zellen den vorgegebenen Zuständen entsprechen.

2. Verfahren nach Anspruch 1, dadurch gekennzeichnet, daß die zu Beginn des Tests erfolgende Verifizierung von Zellenzuständen durch Einschreiben jeweils einer bekannten Information in die betreffenden Zellen erfolgt.

3. Verfahren nach Anspruch 2, dadurch gekennzeichnet,
daß die bekannte Information so beschaffen ist, daß bei ihrem Einschreiben alle beteiligten Zellen den gleichen Zustand einnehmen, und
daß der in der Test-Betriebsart der Rückspeichereinrichtung vorgegebene Frischzustand für alle beteiligten Zellen gleich ist.

4. Verfahren nach Anspruch 3, dadurch gekennzeichnet, daß der in der Test-Betriebsart der Rückspeichereinrichtung vorgegebene Frischzustand ein sich vom verifizierten Zustand fühlbar unterscheidender Zustand irgendwo innerhalb des Gesamtbereichs möglicher Zustände ist.

5. Verfahren nach Anspruch 3 oder 4, wobei die Wähleinrichtung einen Refresh-Adressenzähler enthält, der durch Refresh-Taktimpulse zyklisch über jeweils seinen Zählbereich fortschaltbar ist, welcher N Zählwerte umfaßt, um eine Menge von N Zellen oder Zellengruppen des Speichers in zyklischer Wiederholung für die Auffrischung zu adressieren,
gekennzeichnet durch folgende Schritte:
5A) an die Adresse zumindest einer ausgesuchten Zelle innerhalb jedes der N Elemente der vom Refreshzähler adressierbaren Menge wird eine bekannte Information geschrieben;
5B) vor Ablauf der garantierten Mindest-Retentionszeit und unter Betreiben der Rückspeichereinrichtung in der Test-Betriebsart wird eine Anzahl X von Refresh-Taktimpulsen angelegt;
5C) nach dem Anlegen der X Refresh-Taktimpulse wird geprüft, ob die durch diesen Betrieb der Rückspeichereinrichtung eingestellten Zustände der ausgesuchten Zellen den vorgegebenen Zuständen entsprechen.

6. Verfahren nach Anspruch 5, dadurch gekennzeichnet,
daß zunächst die Schritte 5A bis 5C mit X=N durchgeführt werden;
daß anschließend unter Betreiben der Rückspeichereinrichtung in der Refresh-Betriebsart eine Anzahl Y von Refresh-Taktimpulsen angelegt wird, wobei Y eine andere Zahl als ein ganzzahliges Vielfaches von N ist;
daß anschließend die Schritte 5A bis 5C mit X=N wiederholt werden.

7. Verfahren nach Anspruch 6, dadurch gekennzeichnet, daß Y gleich N/2 ist.

8. Verfahren nach Anspruch 5, wobei am Refreshzähler ein definierter Zählwert voreinstellbar ist oder der momentan existierende Zählwert erkennbar ist,
dadurch gekennzeichnet,
daß zunächst die Schritte 5A bis 5C mit X<N durchgeführt werden;
daß anschließend die Schritte 5A bis 5C wiederholt werden, wobei jedoch mindestens die Anzahl N-X+1 anstatt die Anzahl X von Refresh-Taktimpulsen angelegt wird.

9. Verfahren nach Anspruch 8, dadurch gekennzeichnet, daß X gleich N-1 ist.

10. Verfahren nach einem der vorhergehenden Ansprüche, wobei die Rückspeichereinrichtung eine Schalteinrichtung (S1ₘ, S2ₘ) enthält, die in der Refresh-Betriebsart auf die jeweils ausgewählte Zelle (C_{n,m}) zugreift, um zunächst ein Ausgangssignal (V₁) einer Signalquelle (G) an der Zelle wirksam werden zu lassen, das zum Auslesen der in der Zelle gespeicherten Information in einen zugeordneten Leseverstärker (LV) führt, und dann nach Abkoppeln dieses Signals den Ausgang des Leseverstärkers zum Wiedereinschreiben der gelesenen Information auf die Zelle zu koppeln,
dadurch gekennzeichnet, daß in der Refresh-Betriebsart
das Ausgangssignal (V₁) der Signalquelle (G) auf einen Wert eingestellt wird, der beim Zugreifen auf die ausgewählte Zelle (C_{n,m}) zum Herstellen des für die Test-Betriebsart vorgegebenen Zellenzustandes führt, und
die Schalteinrichtung (S1ₘ, S2ₘ) veranlaßt wird, für die Dauer des Zugriffs das Ausgangssignal der Signalquelle an der Zelle angekoppelt und den Ausgang des Leseverstärkers (LV) von der Zelle abgekoppelt zu halten.

11. Verfahren zum Testen der Refresheinrichtung eines Informationsspeichers, die ausgelegt ist, um die Information, welche in einer Vielzahl von Zellen des Speichers als Zustand der jeweiligen Zelle gespeichert ist, jeweils vor Ablauf einer garantierten Mindest-Retentionszeit aufzufrischen, und die folgendes enthält:
- eine Refresh-Wähleinrichtung zum Auswählen aufzufrischender Zellen des Speichers;
- eine Fühleinrichtung zum Fühlen des Zustandes jeder von der Wähleinrichtung ausgewählten Zelle; und
- eine Rückspeichereinrichtung zum Setzen jeder ausgewählten Zelle in einen Frischzustand, der in einer die Auffrischung bewirkenden Refresh-Betriebsart der Rückspeichereinrichtung die aus dem gefühlten Zustand abgeleitete Information darstellt, wobei:
zu Beginn des Tests die Zustände der am Test zu beteiligenden Zellen verifiziert werden;
vor Ablauf der garantierten Mindest-Retentionszeit nach dieser Verifizierung die Rückspeichereinrichtung in einer Test-Betriebsart betrieben wird, bei welcher der von ihr einzustellende Frischzustand jeder beteiligten Zelle jeweils ein vorgegebener Zustand ist, der sich fühlbar von dem zuvor verifizierten Zustand unterscheidet;
geprüft wird, ob die durch diesen Betrieb der Rückspeichereinrichtung eingestellten Zustände der beteiligten Zellen den vorgegebenen Zuständen entsprechen,
**dadurch gekennzeichnet**, daß
- die Rückspeichereinrichtung eine Schalteinrichtung (S1ₘ, S2ₘ) enthält, die in der Refresh-Betriebsart auf die jeweils ausgewählte Zelle (C_{n,m}) zugreift, um zunächst durch ein Ausgangssignal (V₁) einer Signalquelle (G) die Bitleitung (BLm) der Zelle vorzuladen, und um dann nach Abkoppeln der Signalquelle (G) die in der Zelle gespeicherte Information durch Ansteuerung der zugehörigen Wortleitung (WLn) in einen zugeordneten Leseverstärker (LV) auszulesen, und die anschließend den Ausgang des Leseverstärkers (LV) zum Wiedereinschreiben der gelesenen Information auf die Zelle koppelt,
- in der Refresh-Betriebsart das Ausgangssignal (V₁) der Signalquelle (G) auf einen Wert eingestellt wird, der beim Zugreifen auf die ausgewählte Zelle (C_{n,m}) zum Herstellen des für die Test-Betriebsart vorgegebenen Zellenzustandes führt, und
- die Schalteinrichtung (S1ₘ, S2ₘ) veranlaßt wird, für die Dauer des Vorladens das Ausgangssignal der Signalquelle an der Zelle angekoppelt und den Ausgang des Leseverstärkers (LV) von der Zelle abgekoppelt zu halten.
